# EUROPEAN PATENT SPECIFICATION

(11) **EP 1 811 821 B1**
(45) Date of publication and mention of the grant of the patent: **23.02.2011**
(21) Application number: 06125409.0
(22) Date of filing: 05.12.2006
(51) Int. Cl.: H05K 3/22

(54) **Method of recycling waste printed circuit boards**
Verfahren zur Verwertung von Abfall-Leiterplatten
Procédé de recyclage des cartes de circuit imprimé

(30) Priority: 23.01.2006 CN 200610002019
(43) Date of publication of application: 25.07.2007
(73) Proprietor: Wu, Hsieh Sen, Sindian City Taipei County 231 (TW)
(72) Inventor: Wu, Hsieh Sen, Sindian City Taipei County 231 (TW)
(74) Representative: Viering, Jentschura & Partner

(56) References cited:
- EP-A1- 1 484 119
- WO-A-2004/096711
- GB-A- 2 109 820
- JP-A- 11 034 058
- US-A- 6 089 479

## Description

### FIELD OF THE PRESENT INVENTION

The present invention relates to the method of recycling wasted printed-circuit-board, particularly for the method and equipment thereof in collecting the different metals remaining on the recyclable wasted PCB being converted into recycling industrial materials under the standard of avoiding second pollution.

### BACKGROUND OF THE INVENTION

As everyone knows, the PCB has been largely used in variety of electric products; Worryingly, the heavy metals in the wasted PCBs such as tin, lead and copper etc. can easily cause second social effects of pollution if those wasted PCBs did not collected for recycling or disposed unsuitably when they are discarded as junk; Especially, the brominated epoxy resins of halide in said wasted PCBs are much easier to spoil natural environment; that is why all the environmental protection experts of every country in the world without exception strive for advocating in reducing the utility rate of using halide materials.

Therefore, every country in the world takes the wasted PCBs into noxious entrepreneurial junk under the environmental protection control; Presently, the relating industries already developed some methods to collect and recycle the metal materials and the fiberglass of intermediate material in the wasted PCB, they are comminuting method [for example: the patent numbers of 247281 and 363904 in the patent publication of TAIWAN R.O.C.], direct incinerating method, heating decomposition method, chemical dissolving method and melted inorganic salt method. Patent document EP-A-1 484 119 discloses a method of recycling PCB's, including steps of removing electronic components, heating to eliminate solder, removing copper by applying acid, and water rinsing. However, while recycling disposal of the wasted PCB, some drawbacks still exist in these methods aforesaid as bellow.
1. Comminuting Method:
   First pulverize the wasted PCBs into powder, then sort said powder into two categories of more metallic powder and less metallic powder; Regardless of what kind of powder aforesaid, the ingredients contain mixture of brominated epoxy resins and fiberglass in addition of the metal so that causing not only impurity effect but also certain difficulty in recycling disposal; Especially, both of the recycling value of said brominated epoxy resins and fiberglass after collecting are neglected.
2. Direct Incinerating Method:
   Directly incinerate and melt the wasted PCBs into mixture of fiberglass and metal, then extract the essential metals after cooling; The process not only consumes much energy but also creates environmental pollution issue owing to the toxic hydrogen bromide [BrH] byproduct; Besides, the collected materials, which are low-grade mixture of metal, must re-smelt to purify for recycling use so that the value of direct utilization is very low.
3. Heating Decomposition Method:
   A tremendous amount toxic hydrogen bromide [BrH] gas is produced during heating decomposition process so that seriously jeopardizing natural environment; Excepting the metal being recyclable by sorting, the rest materials such as brominated epoxy resins and fiberglass are not recyclable with potentiality of spoiling environment.
4. Chemical Dissolving Method:
   The metal in the middle layers of the wasted PCBs can not be completely dissolved during dissolving process so that the brominated epoxy resins being mixed up with heavy metals after dissolving process; Thus, the issue of environmental protection still exists.
5. Melted Inorganic Salt Method:
   Collect and recycle metals and fiberglass by putting the wasted PCBs into melted inorganic salt, which having drawbacks as below:
      a. Upon processing temperature over 400°C, the tin, lead and copper in said wasted PCBs will mix into alloy such that becoming low-grade metal mixture, which not only incurring extra cost expense but also wasting time and effort for refinement.
      b. The wasted PCBs will float on the melted inorganic salt as the specific weight of the melted inorganic salt is greater than that of the wasted PCBs; Thereby, the agitating separation process is difficult to directly operate.
      c. The agitating shattering process will fail as the wasted PCBs softening with flexibility after the dissolution of the melted inorganic salt.
      d. The finished PCBs are interconnected by electroplating joint with soldering point being bigger than through-hole such that fiberglass of PCBs being tightly bonded; Thereby, the effect in separating process of fiberglass is relative low due to difficulty.
      e. The fiberglass will be ruined as the wasted PCBs being put in the melted inorganic salt over a long period of time; The collecting of said fiberglass is difficult as operating time in the mix-agitating process and the re-extracting process is uncontrollable and inconsistent;

Meanwhile, the recycling feasibility of shattered fiberglass is relatively reduced.

Accordingly, all the conventional methods aforesaid in disposing wasted PCB are not the ideal perfect disposal method. Therefore, the present invention originates a stepwise way to collect and recycle different materials by different method and step at each stage in accordance with the characteristics of the PCB so as to achieve in creating the best recycling value in consequence of perfect collecting and recycling.

### SUMMARY OF THE INVENTION

The present invention originates a method of recycling wasted printed-circuit-board, whose prime object is to stepwise collect and recycle different materials in the wasted PCB in manner from outer towards inner way in accordance with the structural characteristics of the PCB; Additionally, a suitable recycling procedure is designed in accordance with recycling value such that recycling material obtaining highest recycling value; Thereby, an integrated recycling system is worked out for the everlasting plan in PCB industry.

In other words, the present invention takes advantage of the characteristics of the PCB so as to dispose different recycling material in stage manner, so that different metals remaining on said PCB are sorted out step by step; Thereby, the bromide and the fiberglass of importance in the resins are collected and converted into variety of industrial materials as resource for recycling in order to prevent said wasted PCB from spoiling the natural environment after recycling.

### BRIEF DESCRIPTION OF THE DRAWINGS

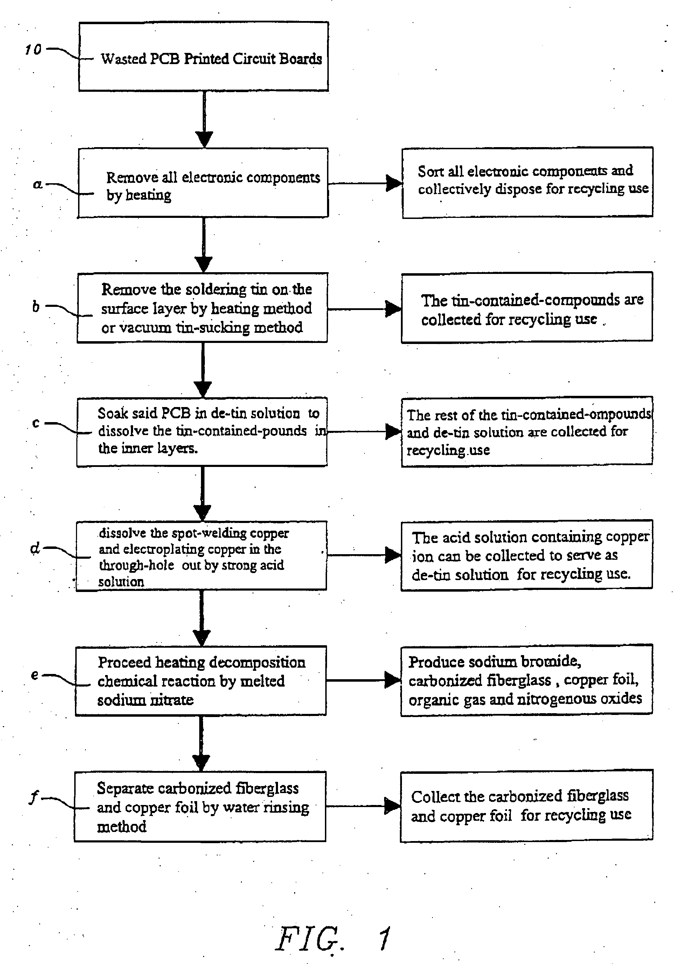

Fig. 1 is the disposal flow chart of the present invention.
Fig. 2 is the illustrative view of the wasted PCB after chemical reaction in the melted sodium nitrate of the present invention.
Fig. 3 is the illustrative view of the recycling equipment thereof to operate in coordination with the present invention.

### DETAILED DESCRIPTION OF THE PREFERRED EMBODIMENTS

As shown in the figures of number 1 and 2, the present invention is a method of recycling wasted printed-circuit-board with disposal steps comprising:
a. Remove all electronic components on all wasted PCBs 10 by heating them on their soldering points such that becoming wasted PCBs without any electronic component then collectively sort and dispose them for recycling use.
   Heat all such wasted PCBs without any electronic component over to 200°C to melt soldering tin on their surface layer so as to remove and collect the tin-contained-compounds, whose melting point being 200°C; then directly collect them by vacuum tin-sucking method for recycling use.
c. Soak said wasted PCBs at step b in de-tin solution of market finished product to dissolve the tin-contained-compounds in the inner layers to separate it from copper; then directly collect all of tin-contained-compounds by said de-tin solution for recycling use.
d. Apply strong acid solution on said wasted PCBs at step c to dissolve the spot-welding copper and electroplating copper in the through-hole out such that becoming wasted PCBs; Wherein, used strong acid solution will become acid solution containing copper ion [Cu⁺⁺] being able to serve as etching solution, and some copper pathways in the inner layers still mix up with fiberglass owing to no contacting with said strong acid.
e. Soak said wasted PCBs at step d in melted sodium nitrate 20 to proceed heating decomposition chemical reaction to separate brominated epoxy resins from fiberglass so as to produce sodium bromide 11, carbonized fiberglass 12, copper foil 13, organic gas 14 and nitrogenous oxides 15;
   Wherein, said sodium bromide 11 can be directly discharged and collected due to harmless to environmental safe, and said organic gas 14 and nitrogenous oxides 15 will become stable nontoxic gas to be discharged out after complete combustion.
f. Separate carbonized fiberglass 12 and copper foil 13 by applying water rinsing method on their mixture formed above; then directly collect said carbonized fiberglass and copper foil for recycling.

Wherein, the strong acid solution used in step d aforesaid can be the diluted nitric acid, either hydrochloric or sulfuric acid mixing with a little nitric acid to sprinkle on said wasted PCBs under oxygen environment.

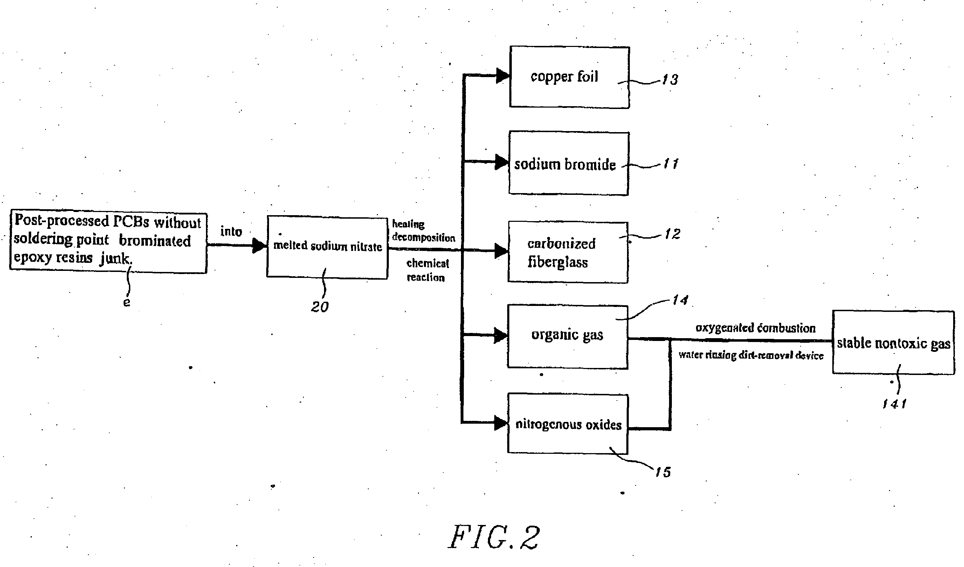

Furthermore, the detail of step d aforesaid is shown in the Fig. 2., employ melted sodium nitrate 20 to directly decompose brominated epoxy resins such that sodium ion [Na⁺] and bromine ion [Br⁻] immediately combining into stable sodium bromide 11; Thus, air pollution and environment pollution can be prevented by discharging said bromide out with gas. After heating decomposition, said epoxy resins will becomes organic gas 14 and black carbon, which adhering to the fiberglass 12. Additionally, the sodium nitrate 20 becomes a nitrate radical ion [NO₃⁻] due to losing its sodium ion [Na⁺]; both of said organic gas 14 and nitrate radical ion [NO₃⁻] will become stable gas after oxygenated combustion; Next, the toxic material contained can be easily removed via operating in coordination with water rinsing dirt-removal device; Thus, not only the bromine element can be collected for recycling use but also the carbonizing of the fiberglass can be enhanced as said fiberglass must via carbonizing reinforcement and increasing surface area to have application convenience for being favorable in recycling use.

Moreover, after water rinsing method in the step f aforesaid, in the mixture of said carbonized fiberglass 12 and copper foil 13, said carbonized fiberglass 12 will float upwards on the water solution while said copper foil 13 will precipitate downwards due to different specific weight comparing to that of water solution respectively; Thereby, the collecting and recycling process of carbonized fiberglass 12 and copper foil 13 becomes easier.

Thus, via all the process steps aforesaid applying on said wasted PCBs 10, all the constituents of the soldering tin, copper, brominated epoxy resins and fiberglass can be easily separated respectively;

Hence, we can adequately work out solutions for both of pollution preventing and product recycling issues through above separating process. Comparing to all conventional process methods of prior art mentioned above, the process method of the present invention has following advantages:
1. Being a nondestructive manner, the process of the present invention has good economical effect as not incurring any recycling cost increase due to destroying material chemical structure.
2. Each process step of the present invention has recycling value effect in easy feasibility and resulting in not only substantially reducing the equipment investing cost but also being simple and convenient in operation.
3. The entire recycling process of the present invention can ensure in avoiding and preventing second pollution with reasons as bellow:
   (1) The nitric acid de-tin solution and hydrochloric acid de-tin solution used in the tin dissolving process is existing market finished product with mature process effect.
   (2) The strong acid used in the copper dissolving process is same as the etching solution used in the conventional PCB manufacturing process so that it can be directly collected to serve as etching solution for recycling use.
   (3) Employ strong oxidizing agent to directly decompose brominated epoxy resins such that sodium ion [Na⁺] and bromine ion [Br⁻] immediately combining into stable bromide and resulting in preventing second pollution.
   (4) The black carbon, attaching on the fiberglass with intact large surface area after heating decomposition, not only make itself increase in the recycling feasibility and process easiness but also make said fiberglass save heating energy in carbonization for being directly collected as recycling material.
   (5) The fiberglass can be easily collected and recycled via simple water rinsing method.
   (6) The copper foil can be easily collected and recycled via simple water rinsing method too.
   (7) Separating the sodium bromide and sodium nitrate is not difficult owing to their difference in physical properties, namely the melting point is 300°C and specific weight is 2.261 for said sodium nitrate while the melting point is 757.7°C and specific weight is 3.203 for said sodium bromide.
   (8) All the variety of recycling materials can create good recycling value without any waste in the process.

Regarding the method for undertaking the heating decomposition in providing said wasted PCBs 10 and sodium nitrate 20, the equipment thereof in recycling wasted printed-circuit-board in the present invention comprises a furnace 30 and a heater 40; Wherein, said furnace 30 comprises a feeding inlet 31, a discharge valve of sodium bromide 32, an gas complete-combustion apparatus 50 and a production outlet 34;

For said feeding inlet 31 with double doors design of exterior door and interior door has working safety in consequence of preventing internal gas from leaking out by means of their interlocking protection of said double doors; Whose operation way is that first put the wasted PCBs 10, which containing brominated epoxy resins and fiberglass, together with the sodium nitrate 20 inside while exterior door being open and interior door being closed; next guide said wasted PCBs 10 and sodium nitrate 20 into said furnace 30 while exterior door being closed and interior door being open; then close the interior door after all feeding stuff getting into said furnace 30 such that double doors in closed status.

Said discharge valve of sodium bromide 32 is to discharge the mixing liquid of said sodium nitrate 20 and sodium bromide 11 out of said furnace 30 after heating decomposition chemical reaction, wherein said sodium bromide 11 being at the undermost of said furnace 30 due to heavier specific weight than that of said sodium nitrate 20;

Said outlet tractor of fiberglass 33 is to draw the carbonized fiberglass and copper foil to said production outlet 34 after heating decomposition chemical reaction, so that subsequently undertaking water rinsing outside of said furnace 30 via said production outlet 34 so as to obtain pure carbonized fiberglass 12 and pure copper foil;

Said heater 40 is to heat said sodium nitrate 20 up to between 350°C and 500°C such that said sodium nitrate 20 becoming melted state.

Thus, via all equipment aforesaid, heating decomposition chemical reaction of said wasted PCBs 10 and sodium nitrate 20 happens in said furnace 30 and the sodium bromide 11, carbonized fiberglass 12, copper foil 13, organic gas 14 and nitrogenous oxides 15 are obtained respectively; Wherein, said sodium bromide 11, fiberglass 12 and copper foil 13 are drawn out of the furnace 30 by said outlet tractor of fiberglass 33 such that removing said sodium bromide 11 and sodium nitrate 20 by water rinsing to obtain carbonized fiberglass 12 and copper foil 13 as industrial materials for recycling use;

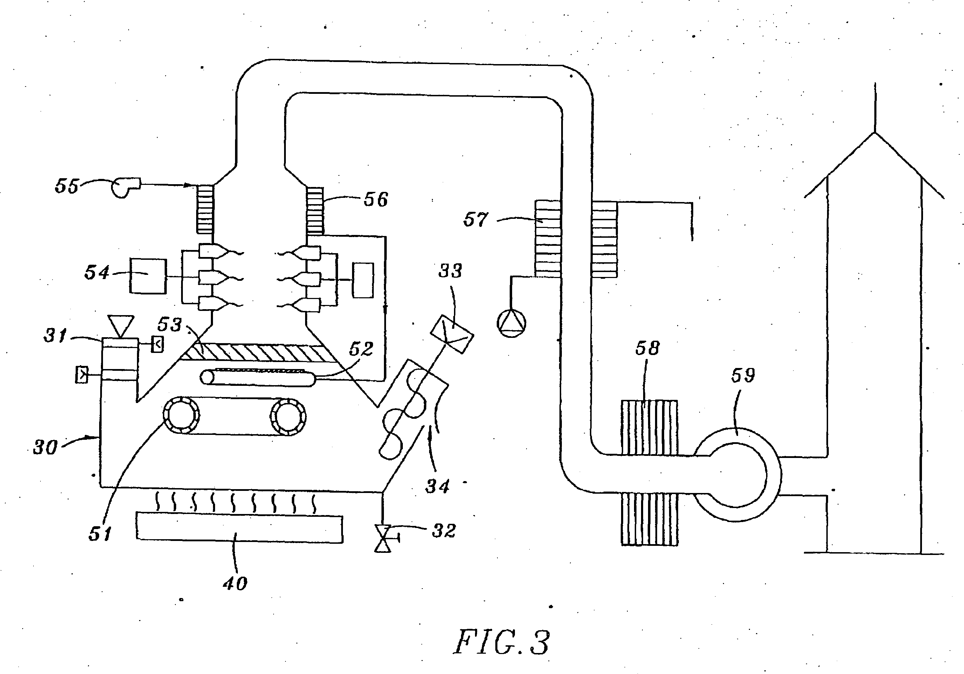

And, said organic gas 14 and nitrogenous oxides 15 will be converted into stable gas 141 after complete combustion in the gas complete-combustion apparatus 50 and water rinsing in the water rinsing dirt-removal device. As shown in the Fig. 3, said gas complete-combustion apparatus 50 mainly comprises a circulating reactor 51, an oxygenated combustion-supporting reactor 52, an air reaction buffing retainer 53, a second heating burner 54, a blower 55, an air heat-exchanger 56, a furnace cooler 57, an air dirt-removal cooler 58 and a pressure equilibrator 59;

Wherein, said circulating reactor 51, which being built in the furnace 30, is to control the reaction time of said wasted PCBs 10 and melted sodium nitrate 20 by transmission speed of connected motor so as to ensure the quality of the fiberglass 12 not being spoiled;

Said oxygenated combustion-supporting reactor 52, which being put above said circulating reactor 51 in the furnace 30, is to supply compressed oxygen so as to enhance the complete combustion of said organic gas 14;

Said air reaction buffing retainer 53, which being constructed above said oxygenated combustion-supporting reactor 52 in the furnace 30, is to stabilize and expedite the gas inside in chemical combination with oxygen of hot air;

Said second heating burner 54, which being put above said air reaction buffing retainer 53, is to increase the reaction temperature in the furnace 30 so as to ensure said organic gas 14 being combusted more completely during second combustion as well as to let air dirt-removal cooler 58 cool them down to become stable gas 141 meanwhile;

Said blower 55, which being disposed above the furnace 30, is to inhale a great quantity of external air into said furnace 30 such that said organic gas 14 and nitrogenous oxides 15 complete combusting quickly so as to eliminate the incomplete combustion phenomena of those gas;

Said air heat-exchanger 56, which being built above said second heating burner 54 over the furnace 30, is to warm and activate the intake cool air by temperature of said furnace 30 so as to have multiple enhancing effects as not only increasing the activity of oxygen for combustion but also reducing the consumption of fuel material as well as accelerating the reaction speed;

Said furnace cooler 57, which being put on the furnace 30, is to exchange heat between the cooling water and the temperature of said furnace 30 under principle of heat exchange so as to cool down the temperature of said furnace 30;

Said air dirt-removal cooler 58 is to remove the dirty material via dust-filtering and adsorption for the gas after combustion, which being then discharged outside after dirt-removal handling to prevent second pollution;

Said pressure equilibrator 59 is to detect and measure the negative pressure in the furnace 30 by pressure transducer, then to adjust the speed of windmill via regulation of the frequency converter by means of pressure controller so as to further equilibrate the pressure in said furnace 30 such that said organic gas 14 being processed in single adequate direction;

Therefore, concluding the exemplary embodiment aforesaid, it is justified that such gas complete-combustion apparatus 50 can really convert the organic gas 14 and nitrogenous oxides 15 into nontoxic stable gas 141 after heat decomposition; Thus, whole process absolutely conforms to every regulations of the environment protection as no harmful material being discharged out.

## Claims

1. A method of recycling waste printed-circuit-boards (PCBs) with disposal steps comprising:
a. Remove all electronic components on all waste PCBs by heating them on their soldering points yielding waste PCBs without any electronic component then collectively sort and dispose of the components for recycling use;
b. Heat all such waste PCBs without any electronic component to over 200°C to melt soldering tin on their surface layer so as to remove and collect the tin-containing-compounds;
c. Soak said waste PCBs at step b in de-tin solution to dissolve the tin-containing-compounds in the inner layers to separate it from copper; then directly collect all of tin-containing-compounds by said de-tin solution for recycling use;
d. Apply strong acid solution on said waste PCBs at step c to dissolve the spot-welding copper and electroplating copper in the through-hole yielding waste PCBS, wherein some copper pathways in the inner layers are still mixed up with fiberglass owing to no contacting with said strong acid solution;
e. Soak said waste PCBs at step d in melted sodium nitrate, potassium nitrate or sodium nitrite to carry-out a heating decomposition chemical reaction to separate brominated epoxy resins from fiberglass so as to produce sodium or potassium bromide, carbonized fiberglass, copper foil, organic gas and nitrogenous oxides; and
f. Separate carbonized fiberglass and copper foil by applying a water rinsing method on the mixture formed above; then directly collect said carbonized fiberglass and copper foil for recycling use.

2. A method of recycling waste printed-circuit-boards as recited in claim 1, wherein, the used strong acid solution in step d will become an acid solution containing copper ion [Cu⁺⁺] being able to serve as an etching solution.

3. A method of recycling waste printed-circuit-boards as recited in claim 1, wherein, the strong acid solution used in step d can be diluted nitric acid, or either hydrochloric acid or sulfuric acid mixing with a little nitric acid to sprinkle on said waste PCBs under oxygen environment.

4. A method of recycling waste printed-circuit-boards as recited in claim 1, wherein, the brominated epoxy resins in step e are decomposed by thermal energy for directly reacting with sodium nitrate to become organic gas and nitrogenous oxides; during which decomposition, sodium ion [Na⁺] and bromine ion [Br⁻] immediately combining into stable sodium bromide to remain in the melted sodium nitrate; and most of the carbon in said epoxy resins will adhere to the fiberglass (12) to let said fiberglass (12) be carbonized.

5. A method of recycling waste printed-circuit-boards as recited in claim 1, wherein, during the step of separating the mixture of said carbonized fiberglass and copper foil in the step f, said carbonized fiberglass will float upwards on the water solution while said copper foil will precipitate downwards due to different specific weight comparing to that of water solution respectively; thereby, the collecting and recycling process of carbonized fiberglass and copper foil becomes easier.

6. A method of recycling waste printed-circuit-boards as recited in claim 1, wherein, said de-tin solution is a nitric acid de-tin solution or a hydrochloric acid de-tin solution.

## Patentansprüche

1. Ein Verfahren zum Recyceln von Abfall-Leiterplatten (PCBs) mit Entsorgungsschritten, das umfasst:
a. Entfernen sämtlicher elektronischer Komponenten auf sämtlichen Abfall-PCBs durch Erwärmen dieser an ihren Lötpunkten, was Abfall-PCBs ohne irgendwelche elektronischen Komponenten ergibt, dann gemeinsames Sortieren und Entsorgen der Komponenten für Recyclingverwendung;
b. Erwärmen sämtlicher Abfall-PCBs ohne irgendwelche elektronischen Komponenten auf über 200 °C, um das Lötzinn auf deren Oberflächenschicht zu schmelzen, um die Zinn-haltigen Verbindungen zu entfernen und zu sammeln;
c. Tränken der Abfall-PCBs aus Schritt b. in Entzinn-Lösung, um die Zinn-haltigen Verbindungen in den inneren Schichten aufzulösen, um sie von Kupfer zu trennen; dann direktes Sammeln sämtlicher Zinn-haltigen Verbindungen durch die Entzinn-Lösung für Recyclingverwendung;
d. Anwenden starker Säurelösung auf den Abfall-PCBs aus Schritt c., um das Punkt-geschweißte Kupfer aufzulösen, und Elektroplattieren des Kupfers in der Durchgangsbohrung, was Abfall-PCBs ergibt, wobei einige Kupferleitungen in den inneren Schichten wegen des Nicht-Kontakts mit der starken Säurelösung noch mit Fiberglas vermischt sind;
e. Tränken der Abfall-PCBs aus Schritt d. in geschmolzenem Natriumnitrat, Kaliumnitrat oder Natriumnitrit, um eine chemische Wärme-Zersetzungsreaktion durchzuführen, um bromierte Epoxidharze von Fiberglas zu trennen, um Natrium- oder Kaliumbromid, karbonisiertes Fiberglass, Kupferfolie, organisches Gas und stickstoffhaltige Oxide zu erzeugen; und
f. Trennen des karbonisierten Fiberglases und der Kupferfolie durch Anwenden eines Wasserspülverfahrens an der oben gebildeten Mischung; dann direktes Sammeln des karbonisierten Fiberglases und der Kupferfolie für Recyclingverwendung.

2. Ein Verfahren zum Recyceln von Abfall-Leiterplatten wie in Anspruch 1 beschrieben, wobei die in Schritt d. verwendete starke Säurelösung zu einer Säurelösung wird, die Kupferion [Cu⁺⁺] enthält, wobei sie als Ätzlösung dienen kann.

3. Ein Verfahren zum Recyceln von Abfall-Leiterplatten wie in Anspruch 1 beschrieben, wobei die in Schritt d. verwendete starke Säurelösung verdünnte Salpetersäure oder entweder Salzsäure oder Schwefelsäure gemischt mit ein wenig Salpetersäure sein kann, um auf die Abfall-PCBs unter Sauerstoffumgebung gespritzt zu werden.

4. Ein Verfahren zum Recyceln von Abfall-Leiterplatten wie in Anspruch 1 beschrieben, wobei die bromierten Epoxidharze in Schritt e. durch thermische Energie für direktes Umsetzen mit Natriumnitrat zersetzt werden, um organisches Gas und stickstoffhaltige Oxide zu werden; wobei während der Zersetzung Natriumion [Na⁺] und Bromion [Br⁻] sofort in stabiles Natriumbromid kombinieren, um in dem geschmolzenen Natriumnitrat zu bleiben; und das Meiste des Kohlenstoffs in dem Epoxidharz wird an dem Fiberglas (12) anhaften, damit das Fiberglas (12) karbonisiert wird.

5. Ein Verfahren zum Recyceln von Abfall-Leiterplatten wie in Anspruch 1 beschrieben, wobei während des Schritts des Trennens der Mischung des karbonisierten Fiberglases und der Kupferfolie in Schritt f., das karbonisierte Fiberglas in der Wasserlösung nach oben gleiten wird, während sich die Kupferfolie aufgrund des unterschiedlichen spezifischen Gewichts verglichen zu dem von Wasser abscheiden wird; wobei dabei das Sammel- und Recyclingverfahren des karbonisierten Fiberglases und der Kupferfolie leichter wird.

6. Ein Verfahren zum Recyceln von Abfall-Leiterplatten wie in Anspruch 1 beschrieben, wobei die Entzinn-Lösung eine Salpetersäure Entzinn-Lösung oder eine Salzsäure Entzinn-Lösung ist.

## Revendications

1. Procédé de recyclage de cartes de circuits imprimés (PCB) de rebut comprenant les étapes d'élimination consistant à :
a. Retirer tous les composants électroniques qui se situent sur tous les PCB de rebut en les chauffant sur leurs points de soudure, ce qui donne des PCB de rebut sans aucun composant électronique, puis trier et collecter de manière collective les composants pour les utiliser en recyclage ;
b. Chauffer tous les PCB de rebut sans aucun composant électronique jusqu'à plus de 200°C pour faire fondre l'étain de soudure présent sur leur couche de surface de manière à enlever et à collecter les composés contenant de l'étain ;
c. Faire tremper lesdites PCB de rebut obtenus à l'étape b dans une solution de désétamage de façon à dissoudre les composés contenant de l'étain dans les couches intérieures de manière à le séparer du cuivre ; ensuite, collecter directement tous les composés contenant de l'étain à l'aide de ladite solution de désétamage pour les utiliser en recyclage ;
d. Appliquer une solution d'acide fort sur lesdits PCB de rebut obtenus à l'étape c de façon à dissoudre le cuivre de soudure par points et le cuivre de dépôt électrolytique dans les trous traversants, ce qui donne des PCB de rebut dans lesquels certains chemins de cuivre dans les couches intérieures sont encore mélangés à de la fibre de verre du fait d'une absence de contact avec ladite solution d'acide fort ;
e. Faire tremper lesdits PCB de rebut obtenus à l'étape d dans du nitrate de sodium, du nitrate de potassium ou du nitrite de sodium fondus, de façon à effectuerune réaction chimique de décomposition par échauffement afin de séparer les résines époxydes bromées de la fibre de verre, de façon à produire du bromure de sodium ou de potassium, de la fibre de verre carbonisée, de la feuille de cuivre, un gaz organique et des oxydes d'azote ; et
f. Séparer la fibre de verre carbonisée et la feuille de cuivre en appliquant un procédé de rinçage à l'eau sur le mélange formé ci-dessus ; ensuite, collecter directement ladite fibre de verre carbonisée et ladite feuille de cuivre pour les utiliser en recyclage.

2. Procédé de recyclage de cartes de circuits imprimés de rebut selon la revendication 1, dans lequel la solution d'acide fort utilisée à l'étape d deviendra une solution d'acide qui contient des ions cuivre [Cu⁺⁺] pouvant servir de solution de gravure.

3. Procédé de recyclage de cartes de circuits imprimés de rebut selon la revendication 1, dans lequel la solution d'acide fort utilisée dans l'étape d peut être de l'acide nitrique dilué, ou un mélange d'acide chlorhydrique ou d'acide sulfurique mélangés avec un peu d'acide nitrique servant à arroser lesdits PCB de rebut dans un environnement d'oxygène.

4. Procédé de recyclage de cartes de circuits imprimés de rebut selon la revendication 1, dans lequel les résines époxydes bromées obtenues à l'étape e sont décomposées par une énergie thermique afin de réagir directement avec du nitrate de sodium de façon à être transformées en gaz organique et en oxydes d'azote ; au cours de laquelle décomposition, les ions sodium [Na⁺] et les ions brome [Br⁻] se combinent immédiatement en bromure de sodium stable de façon à rester dans le nitrate de sodium fondu ; et la majeure partie du carbone présent dans les dites résines époxydes adhérera à la fibre de verre (12) permettant à ladite fibre de verre (12) de se carboniser.

5. Procédé de recyclage de cartes de circuits imprimés de rebut selon la revendication 1, dans lequel, au cours de l'étape consistant à séparer le mélange de ladite fibre de verre carbonisée et de ladite feuille de cuivre dans l'étape f, ladite fibre de verre carbonisée flottera vers le haut sur la solution d'eau tandis que ladite feuille de cuivre précipitera vers le fond en raison du poids spécifique différent par rapport à celui de la solution d'eau respectivement ; de ce fait, le procédé de collecte et de recyclage de la fibre de verre carbonisée et de la feuille de cuivre est facilité.

6. Procédé de recyclage de cartes de circuits imprimés de rebut selon la revendication 1, dans lequel ladite solution de désétamage est une solution de désétamage à l'acide nitrique ou une solution de désétamage à l'acide chlorhydrique.
